# EUROPÄISCHE PATENTANMELDUNG

(11) **EP 4 464 977 A1**
(43) Veröffentlichungstag der Anmeldung: **20.11.2024**
(21) Anmeldenummer: 23173838.6
(22) Anmeldetag: 17.05.2023
(51) Int. Cl.: G01B 11/14, E04B 1/38

(54) **VERFAHREN, COMPUTERPROGRAMMPRODUKT, DATENTRÄGER UND VERWENDUNG**

(71) Anmelder: Schöck Bauteile GmbH, 76534 Baden-Baden (DE)
(72) Erfinder: Die Erfindernennung liegt noch nicht vor
(74) Vertreter: Paul & Albrecht Patentanwälte PartG mbB

(57) **Zusammenfassung**

Verfahren, insbesondere computergestütztes Verfahren, zum Dimensionieren eines Anbauteils (1) zum Anbringen an einem Grundbauteil (2), umfassend die folgenden Schritte:
- Vermessen der Oberflächenkontur des Grundbauteils (2) zumindest in einem Kontaktbereich (3), an welchem das Anbauteil (1) angebracht werden soll;
- Erstellen eines digitalen Zwillings des Grundbauteils (2) auf Basis der vermessenen Oberflächenkontur;
- Dimensionierung des Anbauteils (1), insbesondere einer Kontaktzone (13) des Anbauteils (1), mit welcher das Anbauteil (1) an dem Grundbauteil (2) angebracht werden soll, korrespondierend zu der Oberflächenkontur des Grundbauteils (2) basierend auf dem digitalen Zwilling.

## Beschreibung

Die vorliegende Erfindung betrifft ein Verfahren, insbesondere ein computergestütztes Verfahren, zum Dimensionieren eines Anbauteils zum Anbringen an einem Grundbauteil. Ferner betrifft die Erfindung ein Computerprogrammprodukt, sowie einen computerlesbaren Datenträger. Außerdem betrifft die Erfindung die Verwendung einer Messeinrichtung.

In vielen verschiedenen Bereichen besteht die Notwendigkeit, an ein bestehendes Grundbauteil ein Anbauteil anzubringen. Anbauteile sind dabei häufig vorgefertigte Bauteile, die in einem entsprechenden Bauteilwerk unabhängig von dem Grundbauteil hergestellt werden. Dabei tritt zu Teilen die Problematik auf, dass das Grundbauteil eine Oberflächenkontur mit relativ großen Toleranzen aufweist und das separat hergestellte Anbauteil dem gegenüber enge Toleranzen aufweist, was dazu führen kann, dass ein optimales Anbringen des Anbauteils an dem Grundbauteil schwierig oder nicht möglich ist. Häufig sind dann beim Anbringen zeit- und kostenintensive Korrektur- oder Anpassungsmaßnahmen erforderlich, um eine gute Verbindung zwischen Grund- und Anbauteil herzustellen.

Ein Beispiel für diese Problematik ist das Anbringen von vorgefertigten Bauteilen an bestehenden Bau- bzw. Teilbauwerken. Dabei kann es sich um auskragende Anbauteile handeln, beispielsweise um Balkone oder Balkonböden, die an ein Kontaktbereich eines bestehenden Bauwerks, insbesondere eines Rohbauwerks oder eines fertiggestellten Bauwerks, angebracht werden. Üblicherweise werden dafür zueinander beabstandet mehrere Verbindungsvorrichtungen verwendet, die an einer Seite an dem bestehenden Teilbauwerk oder fertiggestellten Bauwerk befestigt werden. Dazu können Bohrungen in das Bauwerk, beispielsweise in eine Betonstruktur des Bauwerks, eingebracht werden. Die Verbindungsvorrichtungen weisen dazu auf einer Seite korrespondierende Stahlstäbe auf, die in die Bohrungen eingesetzt werden und dann in den Bohrungen vergossen werden. An der anderen Seite der Verbindungsvorrichtungen kann üblicherweise ein Anbauteil, beispielsweise ein auskragendes Anbauteil wie ein Balkonboden angebracht werden. Dazu können die Verbindungsvorrichtungen beispielsweise abragende Gewindestifte aufweisen, an denen eine auskragende Stahlkonstruktion, beispielsweise ein tragender Balkonboden, in einer Kontaktzone befestigt werden kann. Handelt es sich um einen Außenbalkon, sind die Verbindungsvorrichtungen in ihrem mittleren Bereich häufig zusätzlich thermisch isolierend ausgebildet, um Wärmebrücken zu vermeiden.

Häufig ist die Außenoberfläche eines bestehenden Bau- oder Teilbauwerks nicht eben ausgebildet. Die Abweichungen von einer idealen, ebenen Fläche können dabei mehrere Zentimeter betragen. Die Oberflächen einer Wand eines Bauwerks können herstellungsbedingt auch wellig ausgebildet sein. Ein Anbauteil, welches in einer externen Fabrik vorgefertigt wird, verfügt dem gegenüber in der Regel über sehr ebene Oberflächen. Die Abweichungen von einer idealen ebenen Fläche beantragen hier in der Regel höchstens wenige Millimeter.

Wird ein solches Anbauteil, welches sich üblicherweise über eine Länge von mehreren Metern erstreckt, an einem bestehenden Bauwerk angebracht, so ergeben sich unterschiedliche Spaltmaße zwischen dem Kontaktbereich des Grundbauteils und der korrespondierenden Kontaktzone des Anbauteils. Ein ungleiches Spaltmaß zwischen Grundbauteil und Anbauteil führt auch zu einem ungleichmäßigen Lastabtrag. Dies kann im Extremfall zu einer Ermüdung der Verbindungsvorrichtungen bzw. einer Stahlstruktur im Anbauteil führen. Durch die ungleichmäßige Anbringung des Anbauteils an dem Grundbauteil kann ein Benutzer darüber hinaus einen Balkonboden als elastisch nachgebend wahrnehmen. Mit anderen Worten kann der Benutzer einen unerwünschten Federungseffekt bemerken, der auf die ungleichmäßige Lastverteilung in den verschiedenen Verbindungsvorrichtungen zurückgeht.

Grundsätzlich besteht außerdem die Problematik, dass das Grundbauteil und das Anbauteil beim Verbinden unterschiedliche Temperaturen aufweisen können. Im Zusammenhang mit einer Passungenauigkeit durch die unterschiedlichen Toleranzen kann dies zu einem schlechteren Langzeitverhalten betreffend die Ermüdungssicherheit der Verbindungsvorrichtungen führen.

Eine mögliche Abhilfe können hierbei einstellbare Verbindungsvorrichtungen schaffen. Eine solche individuelle Einstellung jeder einzelnen Verbindungsvorrichtung auf einer Baustelle ist jedoch mit hohem apparativem und arbeitstechnischen Aufwand verbunden.

Vor diesem Hintergrund besteht die Aufgabe der vorliegenden Erfindung darin, ein Verfahren zu schaffen, welches ein einfaches, schnelles und stabiles Anbringen von Anbauteilen an Grundbauteilen ermöglicht, wobei insbesondere die zuvor genannten Nachteile vermieden werden.

Diese Aufgabe ist bei einem Verfahren der eingangs genannten Art dadurch gelöst, dass es die folgenden Schritte umfasst:
- Vermessen der Oberflächenkontur des Grundbauteils zumindest in einem Kontaktbereich, an welchen das Anbauteil angebracht werden soll;
- Erstellen eines digitalen Zwillings des Grundbauteils auf Basis der vermessenen Oberflächenkontur;
- Dimensionieren des Anbauteils, insbesondere einer Kontaktzone des Anbauteils, mit welcher das Anbauteil an dem Grundbauteil angebracht werden soll, korrespondierend zu der Oberflächenkontur des Grundbauteils basierend auf dem digitalen Zwilling.

Die Erfindung basiert auf der grundsätzlichen Überlegung, individuell für das jeweilige Grundbauteil ein möglichst passgenaues Anbauteil herstellen zu können. In einem ersten Schritt wird die Oberflächenkontur des Grundbauteils vermessen. Mit anderen Worten wird die Oberfläche mit den darin enthaltenen Unebenheiten und Charakteristika durch eine geeignete Messeinrichtung erfasst. Ausgehend von diesen erfassten Daten wird ein digitaler Zwilling des Grundbauteils erstellt. Das bedeutet, dass eine digitale Abbildung der Oberfläche des Grundbauteils mit den darin enthaltenen Unebenheiten erstellt wird. Dieser digitale Zwilling kann anderen Gewerken bzw. Herstellern zur Verfügung gestellt werden. Auf Grundlage dieses digitalen Zwillings kann dann ein individuelles Anbauteil dimensioniert werden. Das bedeutet, dass die korrespondierende Oberflächenkontur des Anbauteils, insbesondere in einer Kontaktzone, mit welcher das Anbauteil an dem Grundbauteil angebracht werden soll, festgelegt bzw. bestimmt wird. Auf dieser Basis kann die Oberfläche des Anbauteils korrespondierend zu der Oberflächenkontur des Grundbauteils hergestellt werden, so dass ein solches individuell gefertigtes, maßgeschneidertes Anbauteil perfekt an die Oberflächenkontur des Grundbauteils angepasst ist.

Ein ungleichmäßiges Spaltmaß zwischen Grundbauteil und Anbauteil kann damit vermieden werden. Bei entsprechenden statischen Beanspruchungen wird ein gleichmäßiger Lastabtrag über den gesamten Verbindungsbereich realisiert. Dadurch werden beispielsweise bei Balkonböden auch Schwingungen vermieden, da sämtliche Verbindungsvorrichtungen zwischen Grund- und Anbauteil gleichmäßig beansprucht werden. Durch die gleiche Spaltweite, bzw. ein bündiges Anliegen werden Beanspruchungen, beispielsweise Kerbwirkungen, verringert oder vermieden, was sich positiv auf die Standfestigkeit und das Ermüdungsverhalten auswirkt. Gleichzeitig können die Anschlusselemente bzw. Verbindungsvorrichtungen sehr einfach ausgestaltet werden, weil Verstellmechanismen bzw. Ausgleichmöglichkeiten nicht mehr notwendig sind. Eine günstige Passung bzw. die Vermeidung von Spalten erhöht auch die Brandschutzsicherheit. Außerdem können die Montagekosten bzw. der Montageaufwand, der auf einer Baustelle entsteht, verringert werden. Dadurch, dass die Daten digital bereitgestellt werden, ist kein manueller Übertrag oder die manuelle Eingabe von Daten notwendig, um Anbauteile vorzufertigen. Dadurch erhöht sich die Effizienz der Herstellung von Anbauteilen und deren Qualität.

Gemäß einer bevorzugten Ausführungsform ist das Grundbauteil ein Bauwerk oder ein Teilbauwerk. Bei dem Grundbauteil kann es sich um ein fertiggestelltes Bauwerk oder um einen Rohbau handeln. Dementsprechend kann der Kontaktbereich des Grundbauteils ein Teil eines Bodens oder ein Teil einer Decke oder ein Teil einer Seitenwand eines Bauwerks oder eines Teilbauwerks sein. Bei der vermessenen Oberfläche des Grundbauteils kann es sich um eine Betonoberfläche oder eine gemauerte Oberfläche oder eine Holzoberfläche oder eine Stahlträgeroberfläche handeln. Mit anderen Worten kann das erfindungsgemäße Verfahren insbesondere im Baubereich eingesetzt werden.

Das Anbauteil kann ein Stahlträger oder ein Betonelement oder ein Holzbauteil sein oder einen solchen / ein solches umfassen. Möglich ist auch, dass das Anbauteil ein Balkon oder ein Teil eines Balkons, insbesondere ein tragender Balkonboden, ist.

Das Vermessen der Oberflächenkontur des Grundbauteils erfolgt bevorzugt berührungslos. Konkret kann von einer Messeinrichtung ein Sendesignal in Richtung der Oberfläche des Grundbauteils emittiert und ein Rücksignal detektiert werden, welches durch Wechselwirkung des Sendesignals mit der Oberfläche des Grundbauteils entsteht. Auf einer Baustelle herrschen oft spezifische Umgebungsbedingungen, beispielsweise Feuchtigkeit, Kälte und Staubentwicklung. Insofern kann das erfindungsgemäße Verfahren dazu eingesetzt werden, berührungslos die Oberflächenstruktur des Grundbauteils, beispielsweise einer Bauwerksoberfläche, zu vermessen. Das Vermessen kann mit einer Genauigkeit von weniger als 5 mm, insbesondere weniger als 3 mm, bevorzugt weniger als 2 mm, besonders bevorzugt weniger als 1 mm oder weniger als 0,8 mm, erfolgen. Die Genauigkeit bezieht sich vorliegend auf die Abweichung der Oberflächenkontur von einer ideal ebenen Oberfläche. Mit anderen Worten bezieht sich die Genauigkeit auf die Oberflächentopographie, d.h. die Lage der Oberfläche senkrecht zu ihrer Erstreckung.

Prinzipiell ist die Durchführung einer optischen und/oder akustischen Abstandsmessung zwischen Messeinrichtung und Oberfläche des Grundbauteils denkbar. Konkret kann das Sendesignal in Form von elektromagnetischer Strahlung, insbesondere von elektromagnetischer Strahlung mit einer Wellenlänge von 400 nm bis 780 nm, emittiert werden. Die Messeinrichtung kann somit dadurch gekennzeichnet sein, dass sie eine Sendeeinrichtung zum Emittieren von elektromagnetischer Strahlung aufweist. Bevorzugt handelt es sich dabei um elektromagnetische Strahlung im für das menschliche Auge sichtbaren Bereich.

Das Sendesignal kann in Form von Laserstrahlen und/oder Radarstrahlen emittiert werden. Möglich ist auch, dass das Sendesignal nicht in Form von Laserstrahlen emittiert wird. Laserstrahlen zeichnen sich im Gegensatz zu anderen Lichtquellen durch eine hohe Kohärenz, eine hohe Intensität und ein monochromatisches Licht aus.

Konkret kann es sich um eine Lidar-Messung handeln. Bei Lidar, welches die Abkürzung für die englische Begrifflichkeit Light Detection and Ranging ist, handelt es sich um eine Form des dreidimensionalen, optischen Scannens von Oberflächen. Über eine solche insbesondere laserbasierte optische Abstandsmessung kann mit einer hohen Genauigkeit eine Oberflächentopographie erfasst werden. Anstatt der Radiowellen, wie es bei einer Radarmessung der Fall ist, werden vorliegend Lichtstrahlen, insbesondere monochromatische Lichtstrahlen oder Laserstrahlen, verwendet.

In konkreter Ausgestaltung kann das Sendesignal einen Sendeimpuls oder mehrere nacheinander emittierte Sendeimpulse umfassen. Dementsprechend ist es möglich, dass das von einem Sendeimpuls entstehende Rücksignal ausgewertet wird. Möglich ist auch, dass eine Vielzahl von Sendeimpulsen in Richtung der Oberfläche des Grundbauteils gesendet wird. Der Sendeimpuls oder die Sendeimpulse können mit sich verändernder Richtung von einer Sendeeinheit einer Messeinrichtung emittiert werden. Das bedeutet, dass praktisch ein sukzessives Abscannen bzw. Abtasten der Oberflächenkontur stattfindet.

Es kann auch ein flächiges Sensorsignal gesendet werden. Damit ist es möglich, eine unmittelbare flächige Messung der Oberflächenkontur vorzunehmen, ohne dass ein zeitaufwendiges sukzessives Abtasten der Oberfläche erforderlich ist. Dadurch ergeben sich kurze Messzeiten, was die Zuverlässigkeit erhöht, insbesondere da auf Baustellen schwierige Umgebungsbedingungen durch Vibrationen, Staubentwicklung oder dergleichen auftreten können.

Gemäß einer bevorzugten Ausführungsform wird ein rasterförmiges, insbesondere ein rechteckrasterförmiges Sendesignal emittiert. Mit anderen Worten wird auf der Oberfläche, deren Kontur vermessen werden soll, auf eine Vielzahl von Punkten ein Sendesignal gerichtet. Praktisch wird die zu vermessende Oberfläche in eine Vielzahl von Punkten unterteilt. An jedem Punkt wird die exakte Lage der Oberfläche vertikal zur Erstreckung der Oberfläche ermittelt. Somit entsteht datentechnisch eine Punktwolke, d.h. jedem Punkt auf der (zweidimensionalen) Oberfläche wird ein Wert für die Position senkrecht zur Erstreckung der Oberfläche zugeordnet. Das rasterförmige Sendesignal kann mit einem Sendeimpuls oder mit einer Vielzahl von Sendeimpulsen nacheinander emittiert werden. Mit jedem Sendeimpuls kann das gesamte rasterförmige Sendesignal emittiert werden oder einzelne Punkte oder Bereiche.

Das Vermessen der Oberflächenkontur des Grundbauteils kann mehrere Einzelmessungen umfassen. Das bedeutet, dass praktisch die gleiche Messung mehrfach wiederholt wird. Dadurch können Störungen, welche auf Baustellen beispielsweise durch Staubentwicklungen oder Vibrationen auftreten, herausgerechnet werden. Dementsprechend kann basierend auf mehreren Einzelmessungen, wobei jede Einzelmessung datentechnisch eine Punktwolke erzeugen kann, ein Endergebnis des Vermessens der Oberflächenkontur des Grundbauteils ermittelt werden.

In weiterer Ausgestaltung dieser Ausführungsform kann die Rasterweite des Sendesignals kleiner als 10 cm, insbesondere kleiner als 5 cm, bevorzugt kleiner als 3 cm, besonders bevorzugt kleiner als 1 cm, weiter bevorzugt kleiner als 5 mm, kleiner als 3 mm, kleiner als 2,5 mm, kleiner als 2 mm, kleiner als 1,5 mm, oder kleiner als 1 mm sein. Je kleiner die Rasterweite des Sendesignals ist, desto höher ist die Auflösung bei dem Vermessen der Oberfläche und dementsprechend des digitalen Zwillings, auf dessen Basis dann die Dimensionierung des Anbauteils vorgenommen werden kann.

Als Rücksignal kann das an der Oberfläche des Grundbauteils reflektierte und/oder das von der Oberfläche des Grundbauteils rückgestreute Sendesignal detektiert werden. Gemäß einer Ausführungsform kann die Laufzeit (Time of Flight) des Sendesignals und des an der Oberfläche reflektierten oder rückgestreuten Rücksignals ermittelt werden. In diesem Fall kann aus der Laufzeit direkt auf die Distanz, welche das Sendesignal und das Rücksignal zurückgelegt haben, geschlossen werden, woraus wiederum der Abstand der Oberfläche des Grundbauteils von der Messeinrichtung ermittelt werden kann.

Während des Vermessens kann die Messeinrichtung, insbesondere eine das Sendesignal emittierende Sendeeinheit und/oder eine das Rücksignal detektierende Empfangseinheit der Messeinrichtung in einem Abstand von mindestens 1 m, bevorzugt von mindestens 2 m, und/oder von höchstens 8 m, bevorzugt von höchstens 6 m zur Oberfläche des Grundbauteils angeordnet sein. Derartige Abstände haben sich als vorteilhaft herausgestellt, um eine ausreichende Messgenauigkeit zu erzielen und gleichzeitig eine hinreichend große Fläche vermessen zu können.

Zum Detektieren des Rücksignals kann/ können mindestens eine Kamera, bevorzugt mehrere voneinander beabstandete Kameras, bevorzugt genau zwei Kameras verwendet werden. Die Kamera kann dabei in an sich bekannter Weise als Digitalkamera ausgebildet sein. Die mindestens eine Kamera kann dabei Teil der Empfangseinheit der Messeinrichtung sein oder die Empfangseinheit bilden. Mehrere voneinander beabstandete Kameras, insbesondere zwei voneinander beabstandete Kameras sind vorteilhaft, um die Lage der Oberfläche im Raum ermitteln zu können. Sie funktionieren praktisch wie eine Stereokamera. Beispielsweise kann ein Zeitversatz, mit dem ein rückgestreutes oder reflektiertes Sendesignal, welches ein Rücksignal bildet, von den Kameras detektiert wird, zur Bestimmung der Position herangezogen werden. Bei den Kameras kann es sich um TOF-Kameras, welche auch als PMD-Kameras bezeichnet werden, handeln. Derartige Kameras können in der Lage sein, die ganze Oberfläche oder zumindest einen Bereich der Oberfläche des Grundbauteils auf einmal aufzunehmen, so dass eine zeitintensive punkt- oder linienförmige Abtastung nicht erforderlich ist.

Dementsprechend kann die Messeinrichtung eine Sendeeinheit und eine Empfangseinheit enthalten. Diese können integral in einem gemeinsamen Gehäuse der Messeinrichtung untergebracht sein. Prinzipiell möglich ist auch, dass die Sendeeinheit und die Empfangseinheit mit mindestens einer Kamera unabhängig voneinander in einem entsprechenden Abstand zu der zu vermessenden Oberfläche des Grundbauteils positioniert werden.

Das Erstellen eines digitalen Zwillings des Grundbauteils kann in einer Rechnereinheit der Messeinrichtung und/oder in einem externen Rechner, insbesondere im Rechner eines Tablets oder eines Smartphones, stattfinden. Mit anderen Worten kann die Messeinrichtung über eine geeignete Rechnereinheit verfügen, in welcher der digitale Zwilling insbesondere in Form einer Datei erstellt wird. Möglich ist auch, dass die Messeinrichtung die ermittelten Daten an einen externen Rechner, insbesondere an ein Tablet oder ein Smartphone, überträgt, und dort mittels einer geeigneten Software, beispielsweise einer App, eine Erstellung des digitalen Zwillings stattfindet. Dazu kann die Messeinrichtung mit einem externen Rechner beispielsweise drahtgebunden oder drahtlos gekoppelt sein.

Der digitale Zwilling kann in Form einer CAD-Datei insbesondere in Form einer DXF-, DWF-, IGES-, STEP- oder einer STL-Datei erstellt werden. Bei solchen Dateiformaten handelt es sich um übliche Dateiformate zur Abbildung dreidimensionaler Bauteile. Der digitale Zwilling kann nach der Erstellung an andere Gewerke übermittelt werden. Mit anderen Worten können verschiedene Gewerke auf den digitalen Zwilling und damit auf gleiche Daten zugreifen. Dies verringert die Fehleranfälligkeit und den Aufwand bei der Beseitigung von Ungenauigkeiten, da verschiedene Gewerke nunmehr die gleichen Daten nutzen und somit keine Fehler aufgrund von ungenauen oder unterschiedlichen Messergebnissen auftreten können.

Die Dimensionierung, d.h. die Gestaltung des Anbauteils, insbesondere einer Kontaktzone des Anbauteils, dient dazu, die genaue Außenkontur des Anbauteils festzulegen. Die Dimensionierung kann insbesondere zur Herstellung des Anbauteils verwendet werden. Infolge oder auf Basis der Dimensionierung des Anbauteils kann eine CAD-Datei, insbesondere in einem der zuvor genannten Dateiformate, zur Herstellung des Anbauteils bereitgestellt werden.

Das erfindungsgemäße Verfahren kann ferner die Fertigung des Anbauteils entsprechend der Dimensionierung umfassen, so dass eine Kontaktzone des Anbauteils korrespondierend zum Kontaktbereich des Grundbauteils ausgebildet ist. Mit anderen Worten kann auf Basis der durchgeführten Dimensionierung des Anbauteils eine zeit- und ortsunabhängige Fertigung des Anbauteils erfolgen. Dadurch kann sichergestellt werden, dass die Kontaktzone des Anbauteils korrespondierend zum Kontaktbereich des Grundbauteils ausgebildet ist. Insbesondere kann die Kontaktzone des Anbauteils komplementär zu der Oberflächenkontur im Kontaktbereich des Grundbauteils ausgebildet sein. Das bedeutet, dass in Bereichen, in denen die Oberflächenkontur des Grundbauteils gegenüber einer idealen ebenen Oberfläche Vorsprünge aufweist, die Kontur des Anbauteils mit entsprechenden Vertiefungen versehen ist.

Die Fertigung des Anbauteils erfolgt bevorzugt automatisiert oder teilautomatisiert, insbesondere auf Basis einer bereitgestellten Datei, bevorzugt einer CAD-Datei. Auf diese Weise kann das gesamte Verfahren vom Vermessen über das Erstellen eines digitalen Zwillings und die Dimensionierung des Anbauteils bis zur Fertigung des Anbauteils computergestützt ablaufen. Bevorzugt wird die CAD-Datei, auf deren Basis die Fertigung erfolgt, automatisiert erstellt.

Das erfindungsgemäße Verfahren kann darüber hinaus das Anbringen des Anbauteils an dem Grundbauteil derart umfassen, dass zwischen der Kontaktfläche des Grundbauteils in der Kontaktzone des Anbauteils ein Spalt mit einer im Wesentlichen gleichförmigen Spaltbreite ausgebildet ist oder dass das Grundbauteil und das Anbauteil bündig aneinander anliegen. Dadurch, dass die Oberfläche des Anbauteils an die Oberflächenkontur des Grundbauteils angepasst ist, kann eine gleichmäßige Spaltbreite bzw. ein bündiges Anliegen realisiert werden. Auf diese Weise kann eine ungleichmäßige Lastübertragung, aufgrund derer ein aufwendiges Nachjustieren von Verbindungselementen notwendig sein kann, vermieden werden.

Die der Erfindung zugrundeliegende Aufgabe ist ferner gelöst durch ein Computerprogrammprodukt, umfassend Befehle zur Durchführung mindestens eines Schritts des Verfahrens nach einem der vorherigen Ansprüche, insbesondere das Erstellen des digitalen Zwillings und/oder das Dimensionieren des Anbauteils. Das Computerprogrammprodukt kann auch Befehle zur Durchführung sämtlicher Schritte des Verfahrens umfassen.

Ferner ist die der Erfindung zugrunde liegende Aufgabe gelöst durch einen computerlesbaren Datenträger, auf welchem ein solches Computerprogrammprodukt gespeichert ist.

Die der Erfindung zugrunde liegende Aufgabe wird ferner gelöst durch die Verwendung einer Messeinrichtung, welche eine Sendeeinheit, die ausgebildet ist, ein Sendesignal in Richtung der Oberfläche eines Grundbauteils zu emittieren, und eine Empfangseinheit umfasst, die ausgebildet ist, ein Rücksignal zu detektieren, welches durch Wechselwirkung des Sendesignals mit der Oberfläche des Grundbauteils entsteht, zum Vermessen der Oberflächenkontur eines Bauwerks oder eines Teilbauwerks. Insbesondere kann die Messeinrichtung zur Durchführung eines Verfahrens gemäß der Erfindung verwendet werden.

Die Sendeeinheit kann ausgebildet sein, ein Sendesignal in Form von elektromagnetischer Strahlung, insbesondere von elektromagnetischer Strahlung mit einer Wellenlänge von 400 nm bis 780 nm zu emittieren. Bevorzugt ist die Sendeeinheit ausgebildet, ein Sendesignal in Form von Laserstrahlen und/oder Radarstrahlen zu emittieren. Alternativ kann die Sendeeinheit auch derart ausgestaltet sein, dass das Sendesignal nicht in Form von Laserstrahlen emittiert wird. Die Sendeeinheit kann ausgestaltet sein, ein Sendesignal wie im Zusammenhang mit dem Verfahren beschrieben zu emittieren.

In weiterer Ausgestaltung kann die Empfangseinheit eine Kamera, insbesondere mehrere voneinander beabstandete Kameras, bevorzugt genau zwei voneinander beabstandete Kameras umfassen. Die Kameras können als TOF- Kameras ausgebildet sein.

Die Messeinrichtung kann integral ausgebildet sein und ein Gehäuse umfassen, in welchem die Sendeeinheit und die Empfangseinheit, insbesondere mehrere Kameras, untergebracht sind. Die Messeinrichtung kann ferner eine Rechnereinheit umfassen, mit der die Rücksignale, welche durch die Empfangseinheit detektiert werden, ausgewertet und weiterverarbeitet werden. Insbesondere kann die Rechnereinheit ausgestaltet sein, einen digitalen Zwilling einer vermessenen Oberflächenkontur eines Grundbauteils zu erstellen, insbesondere in Form einer CAD-Datei.

Für die weitere Ausgestaltung der Erfindung wird auf die Unteransprüche sowie auf die nachstehende Beschreibung eines Ausführungsbeispiels unter Bezugnahme auf die Zeichnung verwiesen. In der Zeichnung zeigt:

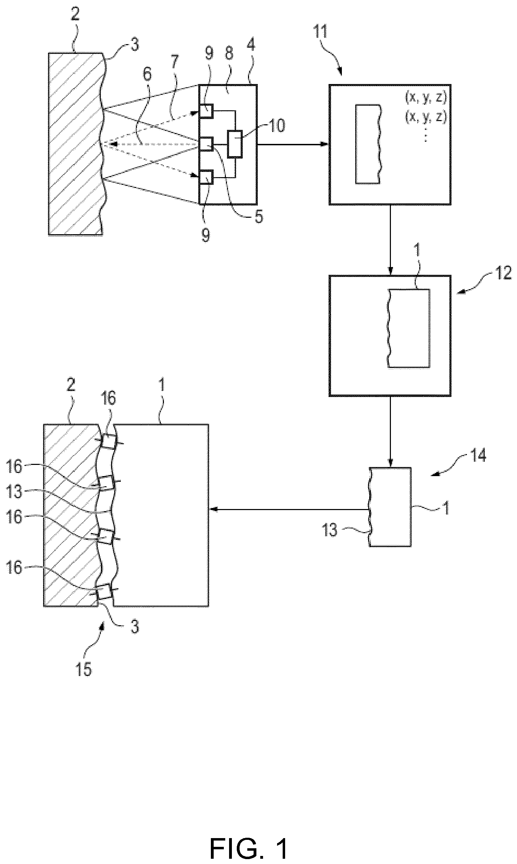

- Figur 1: den Ablauf des erfindungsgemäßen Verfahrens in einer schematischen Darstellung.

Die Figur 1 zeigt ein Verfahren gemäß der vorliegenden Erfindung zum Dimensionieren eines Anbauteils 1 zum Anbringen an einem Grundbauteil 2 in einer schematischen Darstellung. Das Grundbauteil 2 ist in der Figur 1 oben links dargestellt. Dabei handelt es sich vorliegend um einen Abschnitt einer Seitenwand eines Bauwerks, die in einer Schnittansicht dargestellt ist. An einer rechts angeordneten Außenfläche soll ein Anbauteil 1 in Form eines Balkonbodens angebracht werden. Mit anderen Worten bildet die rechts dargestellte Seitenfläche des Grundbauteils 2 einen Kontaktbereich 3.

In einem ersten Schritt wird die Oberflächenkontur des Grundbauteils 2 vermessen. Dazu wird eine Messeinrichtung 4 verwendet, die vorliegend in einem Abstand von etwa 3 Metern von der Oberfläche des Grundbauteils 2 angeordnet ist. Die Messeinrichtung 4 umfasst eine Sendeeinheit 5, welche ein flächiges, rasterförmiges Sendesignal 6 (dargestellt durch Pfeile) in Richtung der Oberfläche des Grundbauteils 2 emittiert. An der Oberfläche des Grundbauteils 2 wird das Sendesignal 6 reflektiert, so dass ein Rücksignal 7, welches ebenfalls in Form von Pfeilen dargestellt ist, sich in Richtung der Messeinrichtung 4 bewegt.

Zum Detektieren des Rücksignals 7 umfasst die Messeinrichtung 4 eine Empfangseinheit 8, welche vorliegend zwei zueinander beabstandete Kameras 9 umfasst. Die beiden Kameras 9 sind jeweils auf einander gegenüberliegenden Seiten der Sendeeinheit 5 angeordnet und mit einer Rechnereinheit 10 der Messeinrichtung 4 verbunden. Durch die Messeinrichtung 4 kann die Oberflächenkontur des Grundbauteils 2 in dem Kontaktbereich 3 vermessen werden. Konkret werden dabei Daten einer Punktwolke erzeugt, d.h. jedem Punkt des Rasters auf der Oberfläche des Grundbauteils 2 wird ein Wert für die Lage des Punkts senkrecht zur Oberfläche zugeordnet.

In einem weiteren Schritt 11 wird ausgehend von diesen Daten durch die Rechnereinheit 10 ein digitaler Zwilling des Grundbauteils 2 erstellt. Dieser digitale Zwilling kann dann bei Bedarf anderen Gewerken zur Verfügung gestellt werden, so dass sämtliche am Bau eines Gebäudes oder am Umbau eines Bauwerks beteiligten Gewerke die gleichen Daten vorliegen haben.

In dem dann folgenden Schritt 12 wird basierend auf dem digitalen Zwilling das Anbauteil 1, hier ein Balkonboden, dimensioniert. Dies erfolgt korrespondierend, vorliegend komplementär, zur Oberflächenkontur des Grundbauteils 2. Konkret wird dabei eine CAD-Datei erstellt, welche die Außenkontur des Anbauteils 1 zumindest in einer Kontaktzone 13, mit welcher das Anbauteil 1 an dem Grundbauteil 2 angebracht werden soll, beschreibt.

Ausgehend von dieser CAD-Datei erfolgt anschließend die Fertigung 14 des Anbauteils 1 in einem entsprechenden Fertigteilwerk. Die Fertigung erfolgt entsprechend der zuvor vorgenommenen Dimensionierung des Anbauteils 1, so dass die Kontaktzone 13 des Anbauteils 1 komplementär zu der Oberflächenkontur im Kontaktbereich 3 des Grundbauteils 2 ausgebildet ist. Bevorzugt erfolgt die Fertigung des Anbauteils 1 automatisiert oder teilautomatisiert, insbesondere auf Basis einer bereitgestellten CAD-Datei.

Im letzten Schritt 15 wird schließlich das Anbauteil 1 an dem Grundbauteil 2 derart angebracht, dass zwischen dem Kontaktbereich 3 des Grundbauteils 2 und der Kontaktzone 13 des Anbauteils 1 ein Spalt mit einer im Wesentlichen gleichförmigen Spaltbreite ausgebildet ist. Konkret werden dazu mehrere Verbindungsvorrichtungen 16 verwendet, die zueinander beabstandet angeordnet sind und auf der einen Seite fest mit der Seitenwand des Grundbauteils 2 verbunden werden und auf der anderen Seite fest mit dem Anbauteil 1 verbunden werden.

Dadurch, dass das Anbauteil 1 derart dimensioniert ist, dass seine Kontaktzone 13 korrespondierend zu der Oberflächenkontur des Grundbauteils 2 ausgebildet ist, entfällt ein aufwendiges Nachjustieren, da die Spaltbreite zwischen dem Anbauteil 1 und dem Grundbauteil 2 aufgrund der individuellen, maßgeschneiderten Fertigung des Anbauteils gleichförmig ausgebildet ist. Dadurch ergeben sich keine ungleichförmigen Belastungen und keine Einschränkung der Gebrauchstauglichkeit des Balkonbodens. Außerdem kann auf der Baustelle eine schnelle Verbindung herbeigeführt werden, da ein aufwendiges Nacharbeiten oder Anpassen oder Justieren des Anbauteils 1 relativ zum Grundbauteil 2 nicht erforderlich ist. Dadurch reduziert sich die Montagezeit. Gleichzeitig können einfachere Verbindungsvorrichtungen 16 verwendet werden, da diese keine aufwendigen Verstellmechanismen und Ausgleichsmöglichkeiten benötigen.

### Bezugszeichenliste

- 1: Anbauteil
- 2: Grundbauteil
- 3: Kontaktbereich
- 4: Messeinrichtung
- 5: Sendeeinheit
- 6: Sendesignal
- 7: Rücksignal
- 8: Empfangseinheit
- 9: Kamera
- 10: Rechnereinheit
- 11: Erstellen des digitalen Zwillings
- 12: Dimensionieren des Anbauteils
- 13: Kontaktzone
- 14: Fertigung des Anbauteils
- 15: Anbringen des Anbauteils am Grundbauteil
- 16: Verbindungsvorrichtung

## Patentansprüche

1. Verfahren, insbesondere computergestütztes Verfahren, zum Dimensionieren eines Anbauteils (1) zum Anbringen an einem Grundbauteil (2), umfassend die folgenden Schritte:
- Vermessen der Oberflächenkontur des Grundbauteils (2) zumindest in einem Kontaktbereich (3), an welchem das Anbauteil (1) angebracht werden soll;
- Erstellen eines digitalen Zwillings des Grundbauteils (2) auf Basis der vermessenen Oberflächenkontur;
- Dimensionierung des Anbauteils (1), insbesondere einer Kontaktzone (13) des Anbauteils (1), mit welcher das Anbauteil (1) an dem Grundbauteil (2) angebracht werden soll, korrespondierend zu der Oberflächenkontur des Grundbauteils (2) basierend auf dem digitalen Zwilling.

2. Verfahren nach Anspruch 1, **dadurch gekennzeichnet, dass** das Grundbauteil (2) ein Bauwerk oder ein Teilbauwerk ist, und/oder dass es sich bei dem Grundbauteil (2) um ein fertiggestelltes Bauwerk oder einen Rohbau handelt, und/oder
dass der Kontaktbereich (3) des Grundbauteils (2) ein Teil eines Bodens oder ein Teil einer Decke oder ein Teil einer Seitenwand eines Bauwerks oder eines Teilbauwerks ist, und/oder
dass es sich bei der vermessenen Oberfläche um eine Betonoberfläche oder eine gemauerte Oberfläche oder eine Holzoberfläche oder eine Stahlträgeroberfläche handelt, und/oder
dass das Anbauteil (1) ein Stahlträger oder ein Betonelement oder ein Holzbauteil ist oder einen solchen/ ein solches umfasst, und/oder
dass das Anbauteil (1) ein Balkon oder ein Teil eines Balkons, insbesondere ein Balkonboden, ist.

3. Verfahren nach einem der vorherigen Ansprüche, **dadurch gekennzeichnet, dass** zum Vermessen der Oberflächenkontur von einer Messeinrichtung (4) ein Sendesignal (6) in Richtung der Oberfläche des Grundbauteils (2) emittiert und ein Rücksignal (7) detektiert wird, welches durch Wechselwirkung des Sendesignals (6) mit der Oberfläche des Grundbauteils (2) entsteht, wobei, insbesondere, das Sendesignal (6) in Form von elektromagnetischer Strahlung, insbesondere von elektromagnetischer Strahlung mit einer Wellenlänge von 400 nm bis 780 nm, emittiert wird.

4. Verfahren nach Anspruch 3, **dadurch gekennzeichnet, dass** das Sendesignal (6) in Form von Laserstrahlen und/oder Radarstrahlen emittiert wird, und/oder dass das Sendesignal (6) nicht in Form von Laserstrahlen emittiert wird.

5. Verfahren nach einem der Ansprüche 3 oder 4, **dadurch gekennzeichnet, dass** das Sendesignal (6) einen Sendeimpuls oder mehrere nacheinander emittierte Sendeimpulse umfasst.

6. Verfahren nach einem der Ansprüche 3 bis 5, **dadurch gekennzeichnet, dass** ein rasterförmiges Sendesignal (6) emittiert wird.

7. Verfahren nach Anspruch 6, **dadurch gekennzeichnet, dass** die Rasterweite des Sendesignals (6) kleiner als 10 cm, insbesondere kleiner als 5 cm, bevorzugt kleiner als 3 cm, besonders bevorzugt kleiner als 1 cm, weiter bevorzugt kleiner als 5 mm, kleiner als 3 mm, kleiner als 2,5 mm, kleiner als 2 mm, kleiner als 1,5 mm und/oder kleiner als 1 mm ist.

8. Verfahren nach einem der Ansprüche 3 bis 7, **dadurch gekennzeichnet, dass** als Rücksignal (7) das an der Oberfläche des Grundbauteils (2) reflektierte und/oder das von der Oberfläche des Grundbauteils (2) rückgestreute Sendesignal (6) detektiert wird, und/oder
dass die Messeinrichtung (4), insbesondere eine das Sendesignal (6) emittierende Sendeeinheit (5) und/oder eine das Rücksignal (7) detektierende Empfangseinheit (8) der Messeinrichtung (4), während des Vermessens der Oberflächenkontur des Grundbauteils (2) in einem Abstand von mindestens 1 m, bevorzugt mindestens 2 m, und/oder höchstens 8 m, bevorzugt höchstens 6 m zur Oberfläche des Grundbauteils (2) angeordnet ist/sind, und/oder
dass zum Detektieren des Rücksignals (7) mindestens eine Kamera (9), insbesondere mehrere voneinander beabstandete Kameras (9), bevorzugt genau zwei Kameras (9) verwendet werden.

9. Verfahren nach einem der vorherigen Ansprüche, **dadurch gekennzeichnet, dass** das Erstellen eines digitalen Zwillings in einer Rechnereinheit (10) der Messeinrichtung (4) und/oder in einem externen Rechner, insbesondere im Rechner eines Tablets oder eines Smartphones, stattfindet, und/oder
dass der digitale Zwilling in Form einer CAD-Datei, insbesondere in einer DXF-, DWF-, IGES-, STEP- oder einer STL-Datei erstellt wird, und/oder dass infolge der Dimensionierung des Anbauteils (1) eine solche CAD-Datei, welche die Außenkontur des Anbauteils (1) zumindest in einer Kontaktzone (13) beschreibt, insbesondere zur Herstellung des Anbauteils bereitgestellt wird.

10. Verfahren nach einem der vorherigen Ansprüche, **dadurch gekennzeichnet, dass** dieses ferner die Fertigung des Anbauteils (14) entsprechend der Dimensionierung umfasst, so dass eine Kontaktzone (13) des Anbauteils (1) korrespondierend zum Kontaktbereichs (3) des Grundbauteils (2) ausgebildet ist.

11. Verfahren nach Anspruch 10, **dadurch gekennzeichnet, dass** die Kontaktzone (13) des Anbauteils (1) komplementär zu der Oberflächenkontur im Kontaktbereich (3) des Grundbauteils (2) ausgebildet wird, und/oder
dass die Fertigung des Anbauteils (14) automatisiert oder teilautomatisiert insbesondere auf Basis einer bereitgestellten CAD-Datei erfolgt, und/oder
dass dieses ferner das Anbringen des Anbauteils (1) an dem Grundbauteil (2) derart umfasst, dass zwischen der Kontaktfläche des Grundbauteils (2) und der Kontaktzone (13) des Anbauteils (1) ein Spalt mit einer zumindest im Wesentlichen gleichförmigen Spaltbreite ausgebildet ist oder dass das Grundbauteil (2) und das Anbauteil (1) bündig aneinander anliegen.

12. Computerprogrammprodukt, umfassend Befehle zur Durchführung mindestens eines Schritts des Verfahrens nach einem der vorherigen Ansprüche, insbesondere das Erstellen des digitalen Zwillings und/oder des Dimensionierens des Anbauteils (1).

13. Computerlesbarer Datenträger, auf welchem das Computerprogrammprodukt nach Anspruch 12 gespeichert ist.

14. Verwendung einer Messeinrichtung (4), welche eine Sendeeinheit (5), die ausgebildet ist, ein Sendesignal (6) in Richtung der Oberfläche eines Grundbauteils (2) zu emittieren, und eine Empfangseinheit (8) umfasst, die ausgebildet ist, ein Rücksignal (7) zu detektieren, welches durch Wechselwirkung des Sendesignals (6) mit der Oberfläche des Grundbauteils (2) entsteht, zum Vermessen der Oberflächenkontur eines Bauwerks oder eines Teilbauwerks, insbesondere zur Durchführung eines Verfahrens nach einem der Ansprüche 1 bis 11.
